Europäisches Patentamt

European Patent Office

Office européen des brevets

(19)

(11) **EP 0 635 136 B1**

(12) **EUROPÄISCHE PATENTSCHRIFT**

(45) Veröffentlichungstag und Bekanntmachung des Hinweises auf die Patenterteilung:
**04.09.1996 Patentblatt 1996/36**

(51) Int Cl.⁶: **G01R 23/167**

(86) Internationale Anmeldenummer:
**PCT/DE93/00262**

(21) Anmeldenummer: **93905213.0**

(22) Anmeldetag: **18.03.1993**

(87) Internationale Veröffentlichungsnummer:
**WO 93/20454 (14.10.1993 Gazette 1993/25)**

(54) **DIGITALE ANORDNUNG ZUM MESSEN DER FREQUENZ EINES ELEKTRISCHEN SIGNALS**

DIGITAL DEVICE FOR MEASURING THE FREQUENCY OF AN ELECTRICAL SIGNAL

SYSTEME NUMERIQUE POUR MESURER LA FREQUENCE D'UN SIGNAL ELECTRIQUE

(84) Benannte Vertragsstaaten:
**CH FR GB LI SE**

(30) Priorität: **06.04.1992 DE 4211946**

(43) Veröffentlichungstag der Anmeldung:
**25.01.1995 Patentblatt 1995/04**

(73) Patentinhaber: **SIEMENS AKTIENGESELLSCHAFT**
**80333 München (DE)**

(72) Erfinder: **SEZI, Tevfik**
**D-12169 Berlin (DE)**

(56) Entgegenhaltungen:
**DE-A- 3 149 165          GB-A- 1 434 028**

- **ELECTRICAL DISIGN NEWS Bd. 34, Nr. 2, Januar 1989, NEWTON,MA,US Seiten 149 - 155 , XP105845 DOVEL 'FFT analysers make spectrum analysis a snap'**

## Beschreibung

Es sind digitale Anordnungen zum Messen der Frequenz eines elektrischen Signals bekannt, die prinzipiell übereinstimmend in der Weise arbeiten, daß durch aufeinanderfolgende Nulldurchgänge eines elektrischen Signals, dessen Frequenz gemessen werden soll, ein Zeitintervall bestimmt wird, während dessen Impulse eines Oszillators in einen Zähler eingezählt werden. Der Zählerstand nach Ablauf des Zeitintervalls stellt dann ein Maß für die zu messende Frequenz dar. Nur beispielhaft sei dazu auf die DE 31 49 165 A1 hingewiesen, in der eine Schaltungsanordnung zur Messung der Frequenz einer Wechselspannung beschrieben ist, bei der mit dem Beginn jeder Periode der Wechselspannung eine Zeitstufe mit einer Zeitablaufdauer angestoßen wird, die der kürzesten erwarteten Periode der Wechselspannung entspricht. Nach Ablauf dieser Zeitstufe wird ein nachgeordneter Zähler angelassen, in den Impulse eines Oszillators solange eingezählt werden, bis durch den Steuerimpuls das Ende der jeweils überwachten Periode angezeigt wird. Aus dem Zählerstand wird die Frequenz errechnet.

Der Erfindung liegt die Aufgabe zugrunde, eine digitale Anordnung zum Messen der Frequenz eines elektrischen Signals anzugeben, mit der sich eine schnelle, störungsfreie und hochgenaue Frequenzbestimmung ermöglichen läßt.

Zur Lösung dieser Aufgabe ist bei einer digitalen Anordnung zum Messen der Frequenz eines elektrischen Signals erfindungsgemäß ein mit dem elektrischen Signal beaufschlagtes linearphasiges, nichtrekursives Digitalfilter mit symmetrischer Verteilung seiner Filterkoeffizienten als ein Allpaßfilter ausgebildet und ein ebenfalls mit dem Signal beaufschlagtes weiteres linearphasiges, nichtrekursives Digitalfilter mit symmetrischer Verteilung seiner Filterkoeffizienten als ein Tiefpaßfilter derart ausgestaltet, daß seine Übertragungsfunktion bei einer vorgegebenen Frequenz des elektrischen Signals den Wert Eins aufweist; dem Allpaßfilter ist eine Schaltungsanordnung nachgeordnet, die in einem Zweig eingangsseitig ein linearphasiges Transversalfilter mit symmetrischer Verteilung seiner Filterkoeffizienten, ein diesem nachgeschaltetes Verzögerungsglied und einen nachgeordneten Multiplizierer enthält und in einem zu dem einen Zweig parallelen Zweig eingangsseitig ein weiteres linearphasiges Transversalfilter mit antisymmetrischer Verteilung seiner Filterkoeffizienten und einem Wert Eins seiner Übertragungsfunktion bei der vorgegebenen Frequenz, ein diesem nachgeschaltetes weiteres Verzögerungsglied und einen nachgeordneten weiteren Multiplizierer aufweist, wobei der eine Multiplizierer eingangsseitig auch mit einem Ausgang des weiteren Transversalfilters und der weitere Multiplizierer auch mit dem Ausgang des einen Transversal filters verbunden ist, und einen Differenzbildner enthält, der mit seinen Eingängen mit den Ausgängen der Multiplizierer verbunden ist; dem Tiefpaßfilter ist eine im Aufbau der Schaltungseinheit identische Schaltungseinrichtung nachgeordnet, die Ausgänge der Differenzbildner der Schaltungseinheit und der Schaltungseinrichtung sind mit einem Quotientenbildner verbunden, dem ein Radizierer nachgeordnet ist, und an den Radizierer ist ein Umkehrfunktionsbildner angeschlossen.

Ein wesentlicher Vorteil der erfindungsgemäßen digitalen Anordnung zum Messen der Frequenz eines elektrischen Signals besteht darin, daß mit ihr die Frequenz sehr genau bestimmt werden kann, weil die Genauigkeit nur noch von der Güte des Quarzes des verwendeten Dszillators und von der Auflösung der benötigten Analog/Digital-Umsetzer abhängig ist. Zur hohen Genauigkeit trägt ferner bei, daß eine Verfälschung der Meßergebnisse durch Bauteiletoleranzen, Alterungserscheinungen und Temperaturschwankungen vermieden ist. Die Verwendung nichtrekursiver Filter vermeidet außerdem Stabilitätsprobleme.

Bei der erfindungsgemäßen digitalen Anordnung können Filter unterschiedlicher Ordnung verwendet werden. Als vorteilhaft wird es jedoch im Hinblick auf eine schnelle Durchführbarkeit der Messung und im Hinblick auf den erforderlichen Aufwand angesehen, wenn alle Filter Filter zweiter Ordnung sind und das Allpaßfilter die Filterkoeffizienten

$a(0) = 0$
$a(1) = 1$
$a(2) = 0,$

das Tiefpaßfilter die Filterkoeffizienten

$t(0) = 0,5$
$t(1) = 1$
$t(2) = 0,5,$

das linearphasige Transversalfilter mit symmetrischer Verteilung seiner Filterkoeffizienten die Filterkoeffizienten

$h(o) = 0$
$h(1) = 1$
$h(2) = 0$

und das linearphasige Transversalfilter mit antisymmetrischer Verteilung seiner Filterkoeffizienten die Filterkoeffizienten

g(0) = - 0,5
g(1) = 0
g(2) = + 0,5

aufweist und die Abtastfrequenz das Vierfache der vorgegebenen Frequenz beträgt.

Die zuverlässige Funktionsweise der erfindungsgemäßen digitalen Anordnung ist daran gebunden, daß ihr eingangsseitig als elektrisches Signal ein nahezu reines Sinussignal zugeführt wird. Da dies in der Praxis, insbesondere bei dem bevorzugten Anwendungsfall der digitalen Anordnung zum Messen der Frequenz in einem elektrischen Energieversorgungsnetz, in der Regel nicht der Fall ist, ist bei einer bevorzugten Ausführungsform der digitalen Anordnung dem Allpaßfilter und dem Tiefpaßfilter gemeinsam ein Bandpaßfilter vorgeordnet, das ein Digitalfilter ist; die Abtastfrequenz des Bandpaßfilters ist ein Vierfaches der Abtastfrequenz der übrigen Filter. Auf diese Weise läßt sich sicherstellen, daß sowohl das Allpaßfilter als auch das Tiefpaßfilter mit einer nahezu reinen Sinusgröße beaufschlagt sind; andererseits läßt sich in einfacher Weise jeweils das Ausgangssignal des Bandpaßfilters unterdrücken, das im Hinblick auf die niedrige Abtastfrequenz der nachgeordneten Filter zur Auswertung nicht benötigt wird.

Zur Erläuterung der Erfindung ist in

Figur 1     in Form eines Blockschaltbildes ein Ausführungsbeispiel einer digitalen Anordnung gemäß der Erfindung, in
Figur 2     die Verteilung der Filterkoeffizienten und der Verlauf des komplexen Frequenzganges eines Allpaßfilters in dem Ausführungsbeispiel nach Figur 1, in
Figur 3     die Verteilung der Filterkoeffizienten und der Verlauf des komplexen Frequenzgang eines in der Anordnung nach Figur 1 verwendeten Tiefpaßfilters, in
Figur 4     die Verteilung der Filterkoeffizienten und der Verlauf des komplexen Frequenzganges eines linearphasigen Transversalfilters in der Schaltungseinheit bzw. in der Schaltungseinrichtung der Anordnung nach Figur 1 und in
Figur 5     die Verteilung der Filterkoeffizienten und der Verlauf des komplexen Frequenzganges eines weiteren linearphasigen Transversalfilters in der Schaltungseinheit bzw. der Schaltungseinrichtung der Anordnung nach Figur 1 wiedergegeben.

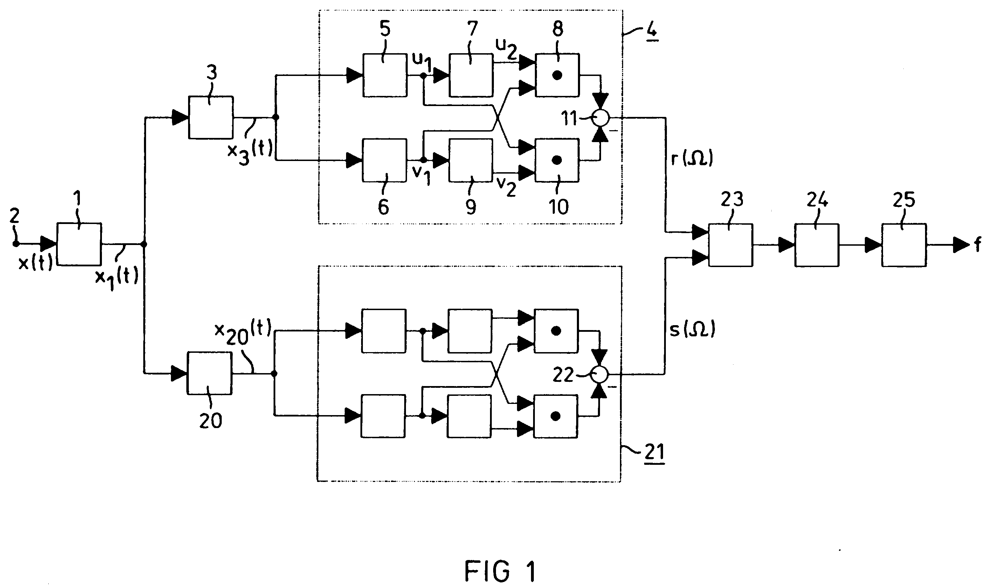

Die in Figur 1 dargestellte digitale Anordnung weist eingangsseitig ein Bandpaßfilter 1 auf, das an seinem Eingang 2 mit einem elektrischen Signal x(t) beaufschlagt ist, dessen Frequenz f gemessen werden soll. Das Bandpaßfilter 1 ist beispielsweise als linearphasiges, nichtrekursives Digitalfilter ausgebildet. Ein derartiges Digitalfilter läßt sich durch seine Übertragungsfunktion $K(j\Omega)$ gemäß folgender Gleichung (1) beschreiben:

$$K(j\frac{\Omega}{})= e^{-j\Omega N/2}\left[\sum_{n=0}^{N/2-1} 2\ k(n)\ \cos\left[\Omega(\frac{N}{2} - n)\right] + k(\frac{N}{2})\right] \qquad (1)$$

In dieser Gleichung (1) beschreibt $\Omega$ die normierte Kreisfrequenz, die sich durch folgende Gleichung (2) definiert ist:

$$\Omega = 2 \cdot \Pi \cdot f \cdot \text{Tab} \qquad (2)$$

In dieser Gleichung bedeutet Tab die Abtastperiodendauer. Die Größe N in Gleichung (1) bezeichnet die Filterordnung, während die Größe k(n) die Filterkoeffizienten des Digitalfilters angibt. Das Bandpaßfilter 1 ist mit seiner Mittenfrequenz $\Omega_0$ auf eine vorgegebene Frequenz abgestimmt, bei der es sich bei einem Einsatz der digitalen Anordnung zum Messen der Frequenz in einem elektrischen Energieversorgungsnetz um die Nenn-Netz-frequenz $f_n$ handelt. Bei einer vorteilhaften praktischen Verwirklichung der Erfindung ist ein Bandpaßfilter 1 der Filterordnung N = 20 verwendet. Am Ausgang des Bandpaßfilters 1 entsteht dann ein elektrisches Signal $x_1(t)$, das auch bei Oberschwingungen ein nahezu reines Sinussignal darstellt.

Das Signal $x_1(t)$ wird unter anderem einem Allpaßfilter 3 zugeführt, das im dargestellten Ausführungsbeispiel von einem linearphasigen, nichtrekursiven Digitalfilter mit symmetrischem Verlauf seiner Filterkoeffizienten und mit der Ordnung N = 2 gebildet ist. Die Filterkoeffizienten des Allpaßfilters 3 sind gewählt zu:

a(0) = 0
a(l) = 1 und
a(2) = 0

Geht man mit diesen Filterkoeffizienten unter Berücksichtigung von N = 2 in die Gleichung (1), dann errechnet sich der komplexe Frequenzgang $A(j\Omega)$ dieses Filters gemäß der nachstehenden Gleichung (3) zu

$$A(j\Omega) = e^{-j\Omega} \tag{3}$$

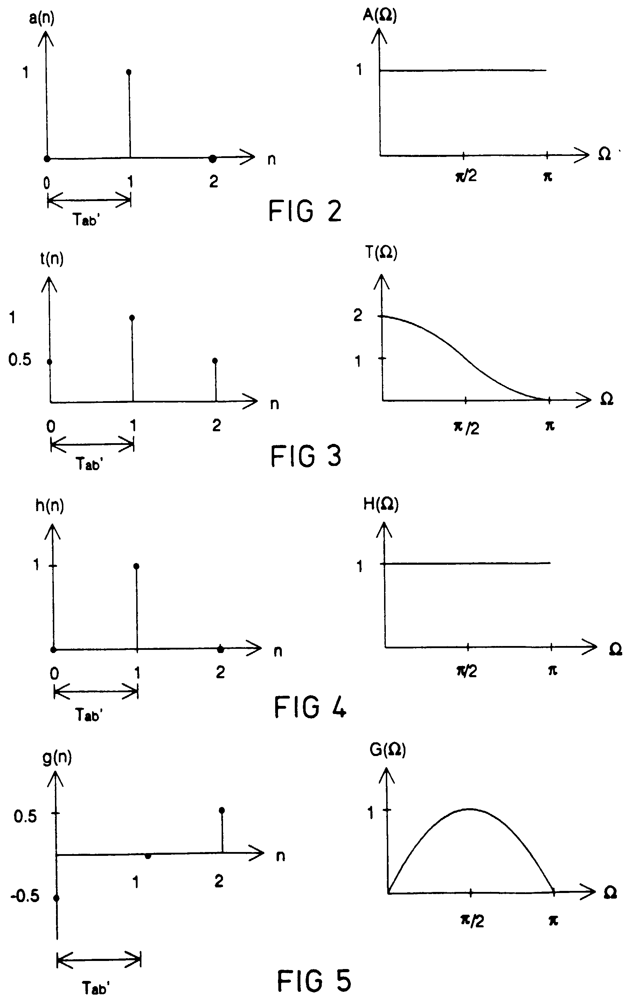

Die rechte Darstellung der Figur 2 gibt den komplexen Frequenzgang des Allpaßfilters 3 über der normierten Kreisfrequenz $\Omega$ wieder. Die linke Darstellung der Figur 2 zeigt die Verteilung der Filterkoeffizienten a(n) in Abhängigkeit von n.

Dem Allpaßfilter 3 ist ausgangsseitig eine Schaltungseinheit 4 nachgeordnet, die eingangsseitig ein linearphasiges Transversalfilter 5 mit symmetrischer Verteilung der Filterkoeffizienten und ein weiteres linearphasiges Transversalfilter 6 mit antisymmetrischer Verteilung seiner Filterkoeffizienten enthält. Das weitere Transversalfilter 6 weist demzufolge ein im Vergleich zu dem einen Transversalfilter 5 differenzierendes Verhalten auf. Das eine Transversalfilter 5 ist Bestandteil eines Zweiges der Schaltungseinheit 4, der außerdem ein nachgeschaltetes Verzögerungsglied 7 und ein diesem nachgeordneten Multiplizierer 8 enthält. Das weitere Transversalfilter 6 ist Bestandteil eines dazu parallelen Zweiges, der dem weiteren Transversalfilter 6 nachgeordnet ein weiteres Verzögerungsglied 9 und einen diesem nachgeordneten weiteren Multiplizierer 10 enthält. Den beiden Multiplizierern 8 und 10 ist ein Differenzbildner 11 nachgeschaltet.

Das eine linearphasige Transversalfilter 5 weist eine komplexe Übertragungsfunktion gemäß der nachfolgenden Gleichung (4) auf:

$$H(j\Omega) = \sum_{n=0}^{N} h(n)\, e^{-j\Omega n}, \tag{4}$$

in der $\Omega$ wiederum die normierte Kreisfrequenz, N die Filterordnung und h(n) die Filterkoeffizienten bezeichnen. Die normierte Kreisfrequenz $\Omega$ ist durch die Gleichung (5) definiert

$$\Omega = 2\Pi f \text{Tab}', \tag{5}$$

in der die Größe Tab' die Abtastfrequenz dieses Filters angibt. Das linearphasige Transversalfilter 5 ist als Allpaßfilter mit dem komplexen Frequenzgang gemäß der nachfolgenden Gleichung (6) ausgebildet:

$$H(j\Omega) = e^{-j\Omega} \tag{6}$$

Es ist ebenfalls von zweiter Ordnung (N = 2) und weist folgende Filterkoeffizienten auf

h(0) = 0
h(1) = 1 und
h(2) = 0

In der rechten Darstellung der Figur 4 ist der komplexe Frequenzgang des einen linearphasigen Transversalfilters 5 über der normierten Kreisfrequenz aufgetragen, während die linke Darstellung der Figur 4 die Verteilung der Filterkoeffizienten h(n) dieses Transversalfilters zeigt.

Das weitere linearphasige Transversalfilter 6 ist ein differenzierendes Filter, das ebenfalls von zweiter Ordnung ist und eine antisymmetrische Verteilung seiner Filterkoeffizienten g(n) aufweist, wie sie in der linken Darstellung der Figur 5 aufgeführt sind. Demzufolge ist

g(0) = - 0,5
g(1) = 0
g(2) = 0,5.

Der komplexe Frequenzgang $G(j\Omega)$ läßt sich durch die nachstehende Gleichung (7) beschreiben:

$$G(j\Omega) = j\, \sin\Omega\, e^{-j\Omega} \tag{7}$$

Der Verlauf des komplexen Frequenzganges ist in der rechten Darstellung der Figur 5 gezeigt. Bei $\Omega = \Pi/2$ ist der Wert der Übertragungsfunktion Eins.

Wie Figur 1 im einzelnen zu entnehmen ist, sind die am Ausgang des einen Transversalfilters 5 sich ergebenden digitalen Werte $u_1$ einerseits über das Verzögerungsglied 7 als Werte $u_2$ dem Multiplizierer 8 zugeführt als auch direkt dem weiteren Multiplizierer 10. Entsprechend sind die digitalen Werte $v_1$ am Ausgang des weiteren linearphasigen Transversalfilters 6 über ein weiteres Verzögerungsglied 9 als Digitalwerte $v_2$ dem weiteren Multiplizierer und direkt dem einen Multiplizierer 8 zugeführt.

Bezeichnet man das abgetastete Signal am Ausgang des Allpaßfilters 3 mit $x_3(t)$, dann läßt sich dies durch die Gleichung (8) beschreiben:

$$x_3(t) = X_3 \sin (\omega t - \varphi_o) \tag{8}$$

in der $\omega$ die Kreisfrequenz des elektrischen Signals x(t) und $\varphi_o$ eine im Bandpaß- und Allpaßfilter aufgetretene Phasenverschiebung angibt. Die Digitalwerte $u_1$ am Ausgang des einen Transversalfilters 5 lassen sich dann durch die folgende Gleichung (9) mit $\varphi_H$ als Phasenverschiebung im Transversalfilter 5 beschreiben:

$$u_1(t) = H(\Omega) X_3 \sin (\omega t - \varphi_0 - \varphi_H). \tag{9}$$

Entsprechend sind die Digitalwerte $v_1$ am Ausgang des weiteren Transversalfilters 6 durch die folgende Gleichung (10) mit $\varphi_G$ als Phasenverschiebung im weiteren Transversalfilter 6 definiert:

$$v_1(t) = G(\Omega) X_3 \sin (\omega t_k - \varphi_0 - \varphi_G) \tag{10}$$

Die Signale $u_2(t)$ und $v_2(t)$ lassen sich durch die Gleichungen (11) und (12) beschreiben:

$$u_2(t) = H(\Omega) X_3 \sin (\omega t_k - \varphi_o - \varphi_H - \varphi_{vz}) \tag{11}$$

$$v_2(t) = G(\Omega) X_3 \sin (\omega t_k - \varphi_o - \varphi_G - \varphi_{vz}), \tag{12}$$

in der $\varphi_{vz}$ die Phasenverschiebung durch die Verzögerungsschaltungen 7 und 9 bezeichnet.

Das am Ausgang des Differenzbildners 11 sich ergebende Verknüpfungssignal $r(\Omega)$ ist - wie eine mathematische Betrachtung anhand der oben aufgeführten Gleichungen ergibt - von den Betragsfrequenzgängen $H(\Omega)$ und $G(\Omega)$, der Verzögerung $\varphi_{vz}$ der Verzögerungsglieder 7 und 9 und von dem Amplitudenquadrat $X_3^2$ des elektrischen Signals $x_3(t)$ am Ausgang des Allpaßfilters abhängig und durch folgende Gleichung (13) beschreibbar:

$$r(\Omega) = H(\Omega) G(\Omega) x_3^2 \sin \varphi_{vz} \tag{13}$$

Wie der Figur 1 ferner entnehmbar ist, ist dem Bandpaßfilter 1 ein Tiefpaßfilter 20 nachgeordnet, das ebenfalls als linearphasiges, nichtrekursives Digitalfilter zweiter Ordnung ausgebildet ist. Die Filterkoeffizienten dieses Tiefpaßfilters 20 sind folgendermaßen gewählt:

t(0) = 0,5
t(1) = 1
t(2) = 0,5.

Es ergibt sich somit ein komplexer Frequenzgang t(j$\Omega$) nach folgender Beziehung (14)

$$T(j\Omega) = [1 + \cos\Omega]e^{-j\Omega} \tag{14}$$

Der komplexe Frequenzgang des Tiefpaßfilters 20 ist in der rechten Darstellung der Figur 3 wiedergegeben und zeigt, daß bei $\Omega = \frac{\Pi}{2}$ der Wert der Übertragungsfunktion Eins ist. Die Phasenverschiebung im Tiefpaßfilter 20 entspricht dabei der Phasenverschiebung im Allpaßfilter 3.

Das Ausgangssignal $x_{20}(t)$ des Tiefpaßfilters 20 wird einer Schaltungseinrichtung 21 zugeführt, die genauso aufgebaut ist wie die Schaltungseinheit 4, die oben detailliert beschrieben worden ist. Bei entsprechender Betrachtung ergibt sich am Ausgang eines weiteren Differenzbildners 22 der Schaltungseinrichtung 21 ein Verknüpfungssignal s($\Omega$), das sich durch folgende Gleichung (15) beschreiben läßt:

$$s(\Omega) = H(\Omega) G(\Omega) X_{20}^2 \cdot \sin\varphi_{vz} \tag{15}$$

Die Verknüpfungssignale r($\Omega$) und s($\Omega$) werden einem Quotientenbildner 23 zugeführt, der an seinem Ausgang ein Signal p($\Omega$) gemäß folgender Gleichung (16) liefert

$$P(\Omega) = s(\Omega)/r(\Omega) = X_{20}^2/X_3^2 = [1 + \cos\Omega]^2 \tag{16}$$

Dem Quotientenbildner 23 ist ein Radizierer 24 nachgeordnet, der aus der ihm zugeführten Eingangsgröße p($\Omega$) die Ausgangsgröße q($\Omega$) bildet, so daß sich die Größe q($\Omega$) durch folgende Gleichung (17) beschreiben läßt:

$$q(\Omega) = \sqrt{p(\Omega)} - 1 = \cos\Omega \tag{17}$$

In einem dem Radizierer 24 nachgeordneten Umkehrfunktionsbildner 25 wird dann die zu messende Frequenz f entsprechend der nachstehenden Gleichung (18) ermittelt:

$$f = 1/2 \, \Pi \, \text{Tab arccos} \, (q(\Omega)) \tag{18}$$

Wesentlich für die Arbeitsweise der beschriebenen Anordnung zum Messen der Frequenz eines elektrischen Signals ist, daß das Tiefpaßfilter 20 und das weitere Transversalfilter 6 der Schaltungseinheit 4 bzw. der Schaltungseinrichtung 21 bei der vorgegebenen Frequenz, beispielsweise bei der Nenn-Frequenz $f_n$ von 50 Hz in einem Energieversorgungsnetz, die Amplitude des elektrischen Signals nicht verändern. Dies wiederum bedeutet - wie die Figuren 3 und 5 erkennen lassen - , daß dies nur dann gewährleistet ist, wenn gewählt ist:

$$\Omega = \Pi/2$$

Daraus wiederum ergibt sich unter Anwendung von Gleichung (2) für Tab':

$$\Omega = \frac{\Pi}{2} = 2 \cdot \Pi \cdot f_n \cdot Tab'$$

$$Tab' = \frac{1}{4f_n}$$

Da die Abtastfrequenz fab' der dem Bandpaßfilter 1 nachgeordneten Filter der Abtastperiodendauer umgekehrt proportional ist, folgt daraus eine dem Vierfachen der vorgegebenen Frequenz $f_n$ entsprechende Abtastfrequenz fab':

$$fab' = 4 \cdot f_n$$

Nach den voranstehenden Ausführungen dürfte klar sein, daß die Frequenzänderungsempfindlichkeit der beschriebenen digitalen Anordnung infolge des quadratischen Zusammenhangs (vgl . beispielsweise Gleichung (16)) eine nichtlineare Funktion ist. Für eine Frequenzänderung $\Delta\Omega/\Omega = 10\%$ ergibt sich:

$$\Delta\, p(\Omega)/p(\Omega) > 0.288 \tag{19}$$

**Patentansprüche**

1. Digitale Anordnung zum Messen der Frequenz eines elektrischen Signals (x(t)),
   **dadurch gekennzeichnet,** daß

   - ein mit dem elektrischen Signal (x(t)) beaufschlagtes linearphasiges, nichtrekursives Digitalfilter mit symmetrischer Verteilung seiner Filterkoeffizienten (a(n)) als ein Allpaßfilter (3) ausgebildet ist,
   - ein ebenfalls mit dem elektrischen Signal (x(t)) beaufschlagtes weiteres linearphasiges, nichtrekursives Digitalfilter mit symmetrischer Verteilung seiner Filterkoeffizienten (t(n)) als ein Tiefpaßfilter (20) derart ausgestaltet ist, daß seine Übertragungsfunktion (T(n)) bei einer vorgegebenen Frequenz ($f_n$) des elektrischen Signals (x(t)) den Wert Eins aufweist,
   - dem Allpaßfilter (3) eine Schaltungseinheit (4) nachgeordnet ist, die

     - in einem Zweig eingangsseitig ein linearphasiges Transversalfilter (5) mit symmetrischer Verteilung seiner Filterkoeffizienten (h(n)), ein diesem nachgeschaltetes Verzögerungsglied (7) und einen nachgeordneten Multiplizierer (8) enthält und
     - in einem zu dem einen Zweig parallelen Zweig eingangsseitig ein weiteres linearphasiges Transversalfilter (6) mit antisymmetrischer Verteilung seiner Filterkoeffizienten (g(n)) und einem Wert Eins seiner Übertragungsfunktion bei der vorgegebenen Frequenz ($f_n$), ein diesem nachgeschaltetes weiteres Verzögerungsglied (9) und einen nachgeordneten weiteren Multiplizierer (10) aufweist, wobei

       - der eine Multiplizierer (8) eingangsseitig auch mit einem Ausgang des weiteren Transversalfilters (6) und der weitere Multiplizierer (10) auch mit dem Ausgang des einen Transversalfilters (5) verbunden ist, und
       - einen Differenzbildner (11) enthält, der mit seinen Eingängen mit den Ausgängen der Multiplizierer (8,10) verbunden ist,

   - dem Tiefpaßfilter (20) eine im Aufbau der Schaltungseinheit (4) identische Schaltungseinrichtung (21) nachgeordnet ist,
   - die Ausgänge der Differenzbildner (11,22) der Schaltungseinheit (4) und der Schaltungseinrichtung (21) mit einem Quotientenbildner (23) verbunden sind, dem ein Radizierer (24) nachgeordnet ist, und
   - an den Radizierer (24) ein Umkehrfunktionsbildner (25) angeschlossen ist.

2. Digitale Anordnung nach Anspruch 1,
   **dadurch gekennzeichnet,** daß

- alle Filter (3,5,6,20) Filter zweiter Ordnung sind und
- das Allpaßfilter (3) die Filterkoeffizienten

$$a(0) = 0$$
$$a(1) = 1$$
$$a(2) = 0,$$

- das Tiefpaßfilter (20) die Filterkoeffizienten

$$t(0) = 0,5$$
$$t(1) = 1$$
$$t(2) = 0,5,$$

- das linearphasige Transversalfilter (5) mit symmetrischer Verteilung seiner Filterkoeffizienten die Filter koeffizienten

$$h(0) = 0$$
$$h(1) = 1$$
$$h(2) = 0 \text{ und}$$

- das linearphasige Transversalfilter (6) mit antisymmetrischer Verteilung seiner Filterkoeffizienten die Filterkoeffizienten

$$g(0) = -0,5$$
$$g(1) = 0$$
$$g(2) = +0,5$$

aufweist und
- die Abtastfrequenz (fab') das Vierfache der vorgegebenen Frequenz ($f_n$) beträgt.

3. Digitale Anordnung nach Anspruch 1 oder 2,
**dadurch gekennzeichnet**, daß

- dem Allpaßfilter (3) und dem Tiefpaßfilter (20) gemeinsam ein Bandpaßfilter (1) vorgeordnet ist, das ein Digitalfilter ist, und
- die Abtastfrequenz des Bandpaßfilters (1) ein Vierfaches der Abtastfrequenz (fab') der übrigen Filter (3,5,6,20) ist.

**Claims**

1. Digital device to measure the frequency of an electrical signal (x(t)), characterized in that

- a linear-phase, non-recursive digital filter, loaded with the electrical signal (x(t)) and having symmetrical distribution of its filter coefficients (a(n)) is constructed as an all-pass filter (3),
- an additional linear-phase, non-recursive digital filter, likewise loaded with the electrical signal (x(t)) and having symmetrical distribution of its filter coefficients (t(n)) is developed as a low-pass filter (20) in such a way that its transfer function (T(n)) at a specified frequency ($f_n$) of the electrical signal (x(t)) has the value "one",
- a circuit unit (4) is arranged downstream of the all-pass tilter (3), which unit

- contains in a branch on the input side a linear-phase transversal filter (5) with symmetrical distribution of its filter coefficients (h(n)), a delay element (7) connected downstream thereof and a subsequently arranged multiplier (8) and
- has in a branch parallel to the one branch on the input side an additional linear-phase transversal filter (6) with antisymmetric distribution of its filter coefficients (g(n)) and a value "one" of its transfer function at the specified frequency ($f_n$), an additional delay element (9) connected downstream thereof and a subsequently arranged additional multiplier (10), whereby

- the one multiplier (8) is connected on the input side also to an output of the additional transversal filter (6) and the additional multiplier (10) is also connected to the output of the one transversal filter (5), and
- contains a difference former (11) which is connected by its inputs to the outputs of the multipliers (8,10),

- a circuit device (21), the assembly of which is identical to that of the circuit unit (4), is arranged downstream of the low-pass filter (20),
- the outputs of the difference formers (11,22) of the circuit unit (4) and the circuit device (21) are connected to a quotient former (23) downstream of which a root extractor (24) is arranged, and
- an inverse function former (2b) is connected to the root extractor (24).

2. Digital device according to claim 1,
   characterized in that

   - all filters (3,5,6,20) are filters of the second order, and
   - the all-pass filter (3) has the filter coefficients

     $a(0) = 0$
     $a(1) = 1$
     $a(2) = 0,$

   - the low-pass filter (20) has the filter coefficients

     $t(0) = 0.5$
     $t(1) = 1$
     $t(2) = 0.5,$

   - the linear-phase transversal filter (5) with symmetrical distribution of its filter coefficients has the filter coefficients

     $h(0) = 0$
     $h(1) = 1$
     $h(2) = 0$ and

   - the linear-phase transversal filter (6) with antisymmetric distribution of its filter coefficients has the filter coefficients

     $g(0) = - 0.5$
     $g(1) = 0$
     $g(2) = + 0.5$ and

   - the sampling frequency (fab') amounts to four times the specified frequency ($f_n$).

3. Digital device according to claim 1 or 2,
   characterized in that

   - a band-pass filter (1) is arranged upstream of both the all-pass filter (3) and the low-pass filter (20), which band-pass filter is a digital filter, and
   - the sampling frequency of the band-pass filter (1) is four times the sampling frequency (fab') of the other filters (3,5,6,20).

**Revendications**

1. Dispositif numérique de mesure de la fréquence d'un signal électrique (x(t)),
   caractérisé en ce que

   - un filtre numérique non récursif à phase linéaire, auquel est appliqué le signal électrique (x(t)) et dont les coefficients (a(n)) de filtre sont répartis symétriquement, est sous la forme d'un filtre (3) passe-tout,

- un autre filtre numérique non récursif à phase linéaire auquel est également appliqué le signal électrique ($x(t)$) et dont les coefficients ($t(n)$) de filtre sont répartis symétriquement est sous la forme d'un filtre passe-bas (20), de manière que sa fonction de transfert ($T(n)$) prendre la valeur une pour une fréquence prescrite ($f_n$) du signal électrique ($x(t)$),
- il est disposé en aval du filtre passe-tout (3) une unité (4) de circuit,

  - qui comprend dans une première branche, en entrée, un filtre transversal (5) à phase linéaire dont les coefficients ($h(n)$) de filtre sont répartis symétriquement, un élément (7) à retard branché en aval de ce filtre transversal (5) et un multiplicateur (8) branché en aval de cet élément à retard (7) et
  - qui comprend, dans une branche parallèle à la première branche, en entrée, un autre filtre transversal (6) à phase linéaire dont les coefficients ($g(n)$) de filtre sont répartis de manière antisymétrique et dont la fonction de transfert prend une valeur une pour la fréquence prescrite ($f_n$), un autre élément (9) à retard branché en aval de ce filtre transversal (6) et un autre multiplicateur (10) disposé en aval de cet élément à retard (9),

    - le multiplicateur (8) étant relié en entrée également à une sortie de l'autre filtre transversal (6) et l'autre multiplicateur (10) étant également relié à la sortie du filtre transversal (5) et
    - l'unité (4) de circuit comprenant un dispositif (11) de formation de différence dont les entrées sont reliées aux sorties des multiplicateurs (8, 10),

- il est disposé en aval du filtre (20) passe-bas un dispositif (21) de circuit de structure identique à celle de l'unité (4) de circuit,
- les sorties des dispositifs (11, 22) de formation de différence de l'unité (4) du circuit et du dispositif (21) de circuit sont reliées à un dispositif (23) de formation de quotient, en aval duquel est disposé un dispositif (24) de formation de racines carrées, et
- un dispositif (25) à fonction d'inversion est connecté au dispositif (24) de formation de racines carrées.

2. Dispositif numérique suivant la revendication 1,
caractérisé en ce que

- tous les filtres (3, 5, 6, 20) sont des filtres du second ordre et
- le filtre (3) passe-tout a les coefficients :

  $a(0) = 0$
  $a(1) = 1$
  $a(2) = 0,$

- le filtre passe-bas (20) a les coefficients :

  $t(0) = 0,5$
  $t(1) = 1$
  $t(2) = 0,5,$

- le filtre transversal (5) à phase linéaire dont les coefficients de filtre sont répartis de manière symétrique a les coefficients :

  $h(0) = 0$
  $h(1) = 1$
  $h(2) = 0$ et

- le filtre transversal (6) à phase linéaire dont les coefficients de filtre sont répartis de manière antisymétrique a les coefficients :

  $g(0) = -0,5$
  $g(1) = 0$
  $g(2) = +0,5$ et

- la fréquence ($fab'$) d'échantillonnage représente quatre fois la fréquence prescrite ($f_n$).

3. Dispositif numérique suivant la revendication 1 ou 2,
   caractérisé en ce que

   - il est disposé en amont du filtre passe-tout (3) et du filtre passe-bas (20) en commun un filtre passe-bande (1), qui est un filtre numérique, et
   - la fréquence d'échantillonnage du filtre passe-bande (1) est égale à quatre fois la fréquence (fab') d'échantillonnage des autres filtres (3, 5, 6, 20).

FIG 1

$x(t)$ $x_1(t)$ $x_3(t)$ $x_{20}(t)$

$u_1$ $u_2$ $v_1$ $v_2$ $r(\Omega)$ $s(\Omega)$ $f$

1 2 3 20 4 21 5 6 7 8 9 10 11 22 23 24 25

FIG 2

FIG 3

FIG 4

FIG 5